# EUROPEAN PATENT SPECIFICATION

(11) **EP 3 235 355 B1**
(45) Date of publication and mention of the grant of the patent: **24.07.2019**
(21) Application number: 15810772.2
(22) Date of filing: 08.12.2015
(51) Int. Cl.: H05K 3/12, B41J 3/407

(54) **3D INK JET PRINTING METHOD**
3D-TINTENSTRAHLDRUCKVERFAHREN
PROCÉDÉ D'IMPRESSION À JET D'ENCRE EN 3D

(30) Priority: 19.12.2014 CN 201410804634
(43) Date of publication of application: 25.10.2017
(73) Proprietor: Tyco Electronics (Shanghai) Co. Ltd., Shanghai 200131 (CN); TE Connectivity Corporation, Berwyn, PA 19312 (US)
(72) Inventor: DENG, Yingcong, Shanghai (CN); OAR, Michael A, Berwyn, Pennsylvania 19312 (US); RADZILOWSKI, Leonard Henry, Berwyn, Pennsylvania 19312 (US); XIN, Liming, Shanghai (CN); LIU, Yun, Shanghai (CN); ZHANG, Dandan, Shanghai (CN); STECK, John Edward, Berwyn, Pennsylvania 19312 (US)
(74) Representative: Grünecker Patent- und Rechtsanwälte PartG mbB
(86) International application number: PCT/IB2015/059442
(87) International publication number: WO 2016/097932

(56) References cited:
- DE-A1- 3 913 028
- DE-A1-102010 004 496
- JP-A- H05 293 955

## Description

### BACKGROUND OF THE INVENTION

### Field of the Invention

Embodiments of the present invention relate to 3D ink jet printing method, and more particularly, relate to 3D ink jet printing method capable of printing out a conductive pattern on a complex surface of a product.

### Description of the Related Art

In the electronics manufacturing industry, it often needs to print a conductive pattern on a surface of an electrical product, for example, print conductive traces on a circuit board. Generally, conductive ink (or referred as conductive adhesive or conductive paste) is ejected on the surface of the electrical product by using an ink jet print head, so as to form the conductive pattern on the surface of the electrical product.

In prior arts, an ink jet printing system generally comprises a horizontal moving mechanism and an ink jet print head mounted on the horizontal moving mechanism and moved together with the horizontal moving mechanism along an X-direction and a Y-direction, perpendicular to each other, in a horizontal plane.

In the prior arts, since the ink jet print head can only be moved along the X-direction and the Y-direction perpendicular to each other, the ink jet printing system is only adapted to print out a conductive pattern on a flat surface of the electrical product, and is not adapted to print out a conductive pattern on a complex surface, comprising a 3D surface region, of the electrical product.

DE 10 2010 004 496 A1 discloses a method and an apparatus for coating and/or printing a workpiece using an ink jet method, wherein one of the workpiece or an ink jet head is moved by means of a multi-axis robot. Multiple known coating processes are applied, and the coating or printing of the workpiece is carried out along a predetermined path. Any deviation from said path is detected and, based on the deviation, a correction signal for controlling the print head is generated.

### SUMMARY OF THE INVENTION

The present invention has been made to overcome or alleviate at least one aspect of the above mentioned problems and disadvantages.

An object of the present invention is to provide 3D ink jet printing method capable of printing out a conductive pattern on a 3D surface of a product.

According to an aspect of the present invention, there is provided a 3D ink jet printing system, comprising: a multi-freedom robot configured to grip and move a product to be printed; and an ink jet print head configured to eject a conductive ink onto a surface of the product to be printed. The surface of the product comprises a 3D surface region, and the 3D ink jet printing system is configured to print out a first conductive pattern on the 3D surface region of the product; the robot is configured to adjust a position and a posture of the product during printing, so that the product moves along a predetermined space path relative to the ink jet print head in a state where the ink jet print head is always substantially perpendicular to a currently printed target surface region of the product.

According to an exemplary embodiment of the present invention, the ink jet print head is stationary during printing.

According to another exemplary embodiment of the present invention, the ink jet print head is movable in at least one of a first direction, a second direction and a third direction, which are perpendicular to each other.

According to another exemplary embodiment of the present invention, during printing, an angle between an axis of the ink jet printing head and a normal line of the currently printed target surface region of the product is in a range of 0∼30 degrees.

According to another exemplary embodiment of the present invention,
the robot is movable in a first direction, a second direction and a third direction, which are perpendicular to each other; and the robot is rotatable about an axis in the first direction, an axis in the second direction and an axis in the third direction.

According to another exemplary embodiment of the present invention, the conductive ink is transmitted to the ink jet print head through a pipe from an ink supply device located far away from the ink jet print head.

According to another exemplary embodiment of the present invention, a gripper, adapted to directly grip the product, is mounted on an end effector of the robot.

According to another exemplary embodiment of the present invention, the 3D ink jet printing system further comprises a fixing device adapted to fix the product and connected to an end effector of the robot by a connection device.

According to another exemplary embodiment of the present invention, the first conductive pattern comprises a point, a curve or a 3D surface printed on the 3D surface region of the product.

According to another exemplary embodiment of the present invention, the robot is configured, during printing the first conductive pattern on the 3D surface region of the product, to adjust the posture of the product, so that an angle between a central axis of a nozzle of the ink jet printing head and a normal line of the 3D surface region is in a range of 0∼30 degrees.

According to another exemplary embodiment of the present invention, the surface of the product further comprises a 2D surface region, and the 3D ink jet printing system is further configured to print out a second conductive pattern on the 2D surface region of the product.

According to another exemplary embodiment of the present invention, the second conductive pattern comprises a point, a straight line, a curve or a 2D plane printed on the 2D surface region of the product.

According to another exemplary embodiment of the present invention, an ink jetting frequency and/or an ink jetting flow rate of the ink jet print head is configured to match with a movement speed of the robot, so that the printed first conductive pattern and/or the printed second conductive pattern has an even thickness.

According to another exemplary embodiment of the present invention, the ink jet print head comprises ink jet print heads of different resolutions configured to print out conductive patterns with different sizes; and/or wherein the ink jet print head comprises ink jet print heads adapted to eject conductive inks of different materials.

According to an aspect of the present invention, there is provided a 3D ink jet printing method, comprising steps of:
S100: constructing an ideal 3D digital model of a product to be printed;
S200: obtaining parameters of a conductive pattern to be printed on a surface of the product based on the constructed ideal 3D digital model;
S300: planning a printing path for the conductive pattern based on the obtained parameters of the conductive pattern;
S400: calculating working parameters of a robot and an ink jet print head based on the panned printing path;
S500: manipulating the robot and the ink jet print head to print the conductive pattern based on the calculated working parameters; and
S600: monitoring a print quality of the conductive pattern printed on the surface of the product and adjusting the working parameters in real time, so that the print quality meets preset requirements,
wherein the surface of the product comprises a 3D surface region, and the conductive pattern comprises a first conductive pattern printed on the 3D surface region of the product, and
wherein the robot adjusts a position and a posture of the product during printing, so that the product moves along the panned printing path relative to the ink jet print head in a state where the ink jet print head is always substantially perpendicular to a currently printed target surface region of the product.

According to an exemplary embodiment of the present invention, the ink jet print head is stationary during printing.

According to another exemplary embodiment of the present invention, the ink jet print head is movable in at least one of a first direction, a second direction and a third direction, which are perpendicular to each other.

According to another exemplary embodiment of the present invention, during printing, an angle between an axis of the ink jet printing head and a normal line of the currently printed target surface region of the product is in a range of 0∼30 degrees.

According to another exemplary embodiment of the present invention, the parameters of the conductive pattern comprise a shape, a size, a position and an orientation of the conductive pattern.

According to another exemplary embodiment of the present invention, the working parameters of the robot comprise kinematic parameters and dynamic parameters of the robot; and the working parameters of the ink jet print head comprise an ink jetting frequency, an ink jetting flow rate, an ink temperature and an ink jet pressure.

According to another exemplary embodiment of the present invention, the step S600 comprises steps of:
S610: scanning the printed product with a 3D scanner and constructing an actual 3D digital model of the printed product;
S620: comparing the actual 3D digital model of the printed product and the ideal 3D digital model of the product; and
S630: determining whether or not a difference between the actual 3D digital model and the ideal 3D digital model is less than or equal to a preset threshold, and if not, adjusting the working parameters in real time until the difference becomes less than or equal to the preset threshold.

According to another exemplary embodiment of the present invention, the working parameters are adjusted by a closed loop feedback control algorithm until the print quality meets the preset requirements.

According to another exemplary embodiment of the present invention, the working parameters of the ink jet print head are controlled to match with the working parameters of the robot, so that the conductive pattern printed on the product has an even thickness.

According to another exemplary embodiment of the present invention, the robot is movable in a first direction, a second direction and a third direction, which are perpendicular to each other; and the robot is rotatable about an axis in the first direction, an axis in the second direction and an axis in the third direction.

According to another exemplary embodiment of the present invention, the first conductive pattern comprises a point, a curve or a 3D surface printed on the 3D surface region of the product.

According to another exemplary embodiment of the present invention, during printing the first conductive pattern on the 3D surface region of the product, the robot adjusts the posture of the product, so that an angle between a central axis of a nozzle of the ink jet printing head and a normal line of the 3D surface region is in a range of 0∼30 degrees.

According to another exemplary embodiment of the present invention, the surface of the product further comprises a 2D surface region, and the conductive pattern further comprises a second conductive pattern printed on the 2D surface region of the product.

According to another exemplary embodiment of the present invention, the second conductive pattern comprises a point, a straight line, a curve or a 2D plane printed on the 2D surface region of the product.

In the 3D ink jet printing method according to embodiments of the present invention, the multi-freedom robot grips the product and adjusts a position and a posture of the product during printing, so that the product moves along a predetermined space path relative to the ink jet print head in a state where the ink jet print head is always substantially perpendicular to a currently printed target surface region of the product. In this way, a conductive pattern can be printed on a 3D surface region of the product.

### BRIEF DESCRIPTION OF THE DRAWINGS

The above and other features of the present invention will become more apparent by describing in detail exemplary embodiments thereof with reference to the accompanying drawings, in which:
Fig.1 is an illustrative perspective view of a 3D ink jet printing system according to an exemplary embodiment; and
Fig.2 is a partially enlarged view of the 3D ink jet printing system shown in Fig.1.

### DETAILED DESCRIPTION OF PREFERRED EMBODIMENTS OF THE INVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to a general concept of the present invention, there is provided a 3D ink jet printing system, comprising: a multi-freedom robot configured to grip and move a product to be printed; and an ink jet print head configured to eject a conductive ink onto a surface of the product to be printed. The surface of the product comprises a 3D surface region, and the 3D ink jet printing system is adapted to print out a first conductive pattern on the 3D surface region of the product. The robot is configured to adjust a position and a posture of the product during printing, so that the product moves along a predetermined space path relative to the ink jet print head in a state where the ink jet print head is always substantially perpendicular to a currently printed target surface region of the product.

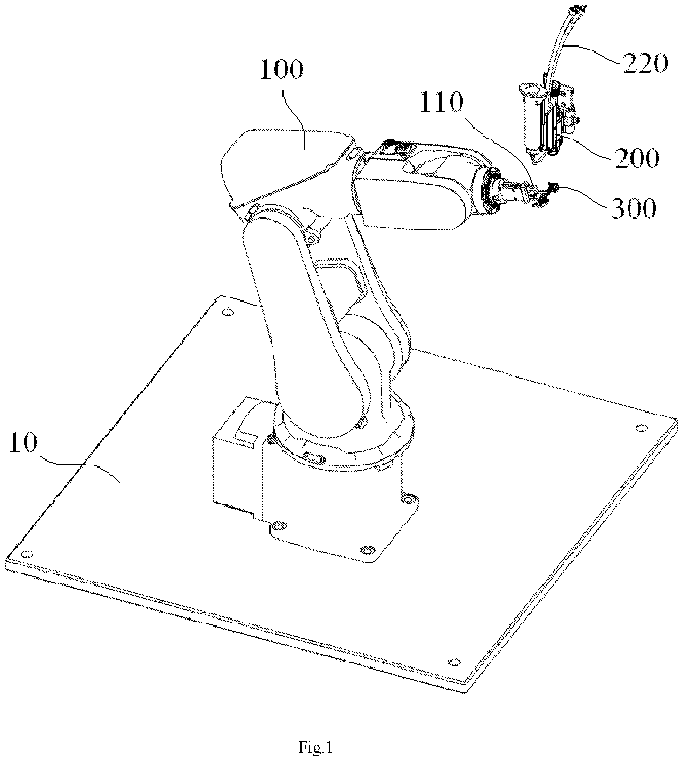

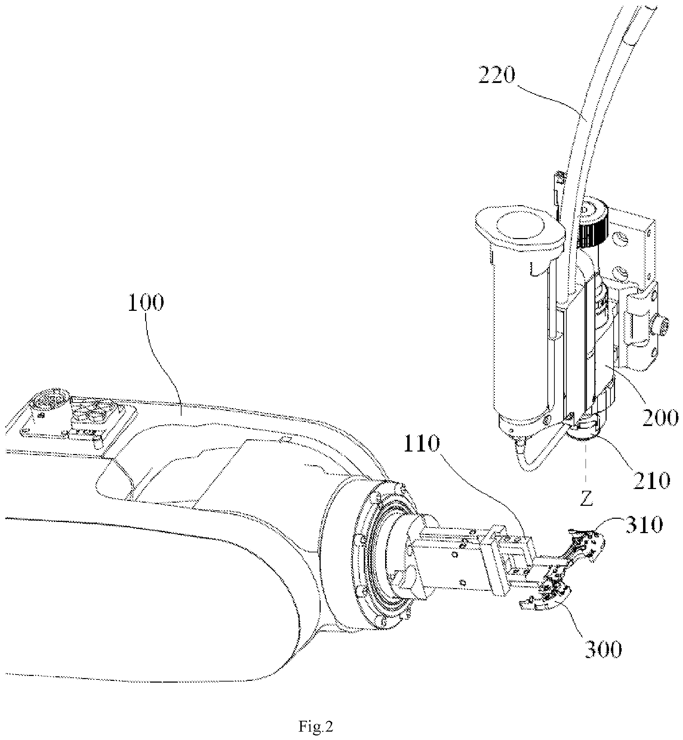

Fig.1 is an illustrative perspective view of a 3D ink jet printing system according to an exemplary embodiment; and Fig.2 is a partially enlarged view of the 3D ink jet printing system shown in Fig. 1.

In an exemplary embodiment of the present invention, there is disclosed a 3D ink jet printing system. As shown in Figs.1 and 2, the 3D ink jet printing system mainly comprises a multi-freedom robot 100 and an ink jet print head 200. The multi-freedom robot 100 is configured to grip and move a product 300 to be printed. The ink jet print head 200 is configured to eject a conductive ink onto a surface of the product 300 to be printed.

As clearly shown in Fig.2, in an embodiment, the surface of the product 300 comprises a 3D surface region 310, and the 3D ink jet printing system is adapted to print out a first conductive pattern on the 3D surface region 310 of the product 300.

In an embodiment, the robot 100 is configured to adjust a position and a posture of the product 300 during printing, so that the product 300 moves along a predetermined space path relative to the ink jet print head 200in a state where the ink jet print head 200 is always substantially perpendicular to a currently printed target surface region of the product 300. For example, in an embodiment, during printing, an angle between an axis Z of the ink jet printing head 200, in which the ink jet printing head 200 eject ink, and a normal line of the currently printed target surface region of the product 300 is in a range of 0∼30 degrees. In another embodiment, an angle between the axis Z of the ink jet printing head 200 and the normal line of the currently printed target surface region of the product 300 is in a range of 0∼10 degrees.

In one example, the ink jet print head 200 may be fixed on a stationary bracket (not shown). In this way, during printing, the ink jet print head 200 is stationary. But the present invention is not limited to this, the ink jet print head may be movable in at least one of a first direction, a second direction and a third direction, which are perpendicular to each other. In the latter case, during printing, the ink jet print head may be moved in at least one of the first direction, the second direction and the third direction.

As shown in Fig.1, a base of the robot 100 is mounted on a stationary seat 10. In an embodiment, the robot 100 has six freedoms, that is, the robot 100 is movable in the first direction, the second direction and the third direction and rotatable about an axis in the first direction, an axis in the second direction and an axis in the third direction. In this way, during printing, the robot may adjust the position and the posture of the product in real time based on control instructions, so that the ink jet printing head prints out the first conductive pattern on the 3D surface region 310 of the product.

In an embodiment, the first conductive pattern may comprise a point, a curve or a 3D surface formed or printed on the 3D surface region 310 of the product 300. As shown in Fig.2, during printing the first conductive pattern on the 3D surface region 310 of the product 300, the robot 100 adjusts the posture of the product 300, so that the central axis Z of a nozzle 210 of the ink jet printing head 200 is always substantially perpendicular to a currently printed 3D surface region of the product 300, for example, so that an angle between the axis Z of the nozzle 210 of the ink jet printing head 200 and the normal line of the 3D surface region 310 is in a range of 0∼30 degrees.

As shown in Figs. 1 and 2, the conductive ink is transmitted to the ink jet print head 200 through a pipe 220 from an ink supply device located far away from the ink jet print head 200. If possible in space, the ink supply device may be provided on the ink jet print head 200.

As shown in Figs.1 and 2, a gripper 110, adapted to grip the product 300, is mounted on an end effector or end arm of the robot 100. The gripper 110 may be a finger type gripper adapted to directly grip the product 300.

Although it is not shown, in another embodiment, the 3D ink jet printing system may comprise a fixing device adapted to fix the product 300. The fixing device may be connected to the end effector of the robot 100 by a connection device. In this way, the product 300 may be fixed on the end effector of the robot 100 by means of the fixing device. After the printing, the product 300 may be detached from the robot 100 by disengaging the connection device from fixing device.

In another embodiment, the surface of the product 300 may further comprise a 2D surface region, and the 3D ink jet printing system may be further configured to print out a second conductive pattern on the 2D surface region of the product 300. The second conductive pattern may comprise a point, a straight line, a curve or a 2D plane printed on the 2D surface region of the product 300.

In another embodiment, an ink jetting frequency and/or an ink jetting flow rate of the ink jet print head 200 matches with a movement speed of the robot 100, so that the printed first conductive pattern and/or the printed second conductive pattern has an even thickness.

In another embodiment, the ink jet print head 200 may comprise ink jet print heads with different resolutions configured to print out conductive patterns with different sizes. For example, a conductive trace with a larger width may be printed out by an ink jet print head of low resolution with a larger nozzle; a conductive trace with a smaller width may be printed out by an ink jet print head of high resolution with a smaller nozzle. In this way, during printing, an ink jet print head with proper resolution may be selected to perform printing operations based on parameters of an object to be printed, thereby improving printing efficiency.

In another embodiment, the ink jet print head 200 may comprise ink jet print heads adapted to eject different kinds of conductive inks, for example, to eject conductive inks of different materials. In this way, it may print out conductive patterns with different conductive properties on the surface of the product.

Hereafter, a 3D ink jet printing method according to an exemplary embodiment of the present invention will be described in detail with reference to Figs.1 and 2. The 3D ink jet printing method mainly comprises steps of:
S100: constructing an ideal 3D digital model of a product 300 to be printed;
S200: obtaining parameters of a conductive pattern to be printed on a surface of the product 300 based on the constructed ideal 3D digital model;
S300: planning a printing path for the conductive pattern based on the obtained parameters of the conductive pattern;
S400: calculating working parameters of a robot 100 and an ink jet print head 200 based on the panned printing path;
S500: manipulating the robot 100 and the ink jet print head 200 to print the conductive pattern based on the calculated working parameters; and
S600: monitoring a print quality of the conductive pattern printed on the surface of the product 300 and adjusting the working parameters in real time, so that the print quality meets preset requirements.

During printing, the robot 100 adjusts a position and a posture of the product 300, so that the product 300 moves along the panned printing path relative to the ink jet print head 200in a state where the ink jet print head 200 is always substantially perpendicular to a currently printed target surface region of the product 300. In this way, it may print out a first conductive pattern on a 3D surface region 310 of the product 300.

In the above method, the parameters of the conductive pattern may comprise a shape, a size, a position and an orientation of the conductive pattern.

In the above method, the working parameters of the robot 100 may comprise, but not limited to, kinematic parameters and dynamic parameters of the robot 100. The working parameters of the ink jet print head 100 may comprise, but not limited to, an ink jetting frequency, an ink jetting flow rate, an ink temperature and an ink jetting pressure.

In the above method, the step S600 may comprise steps of:
S610: scanning the printed product 300 with a 3D scanner and constructing an actual 3D digital model of the printed product 300;
S620: comparing the actual 3D digital model of the printed product 300 and the ideal 3D digital model of the product 300; and
S630: determining, based on the comparing in S620, whether or not a difference between the actual 3D digital model and the ideal 3D digital model is less than or equal to a preset threshold, and if not, adjusting the working parameters in real time until the difference becomes less than or equal to the preset threshold, thereby meeting preset requirements for the print quality.

In the above method, the working parameters of the robot and the ink jet print head may be adjusted by a closed loop feedback control algorithm, for example, a typical PID control algorithm or a neural network control algorithm, until the print quality meets the preset requirements.

In an embodiment, the working parameters of the ink jet print head 200 may be controlled to match with the working parameters of the robot 100, so that the conductive pattern printed on the product 300 has an even thickness.

In the above method, as shown in Fig.2, during printing the first conductive pattern on the 3D surface region 310 of the product 300, the robot 100 adjust the posture of the product 300, so that the central axis Z of the nozzle 210 of the ink jet print head 200 is always substantially perpendicular to the 3D surface region of the product 300, for example, so that an angle between the central axis Z of the nozzle 210 of the ink jet printing head 200 and the normal line of the 3D surface region 310 is in a range of 0∼30 degrees. The first conductive pattern may comprise a point, a curve or a 3D surface printed on the 3D surface region 310 of the product 300.

In another embodiment, the surface of the product 300 may further comprise a 2D surface region, and the 3D ink jet printing system may be further configured to print out a second conductive pattern on the 2D surface region of the product 300. The second conductive pattern may comprise a point, a straight line, a curve or a 2D plane printed on the 2D surface region of the product 300.

In an embodiment, the actual 3D digital model of the printed product 300 and the ideal 3D digital model of the product 300 may be constructed by computer aided design and manufacturing software, for example, CAD software.

It should be appreciated for those skilled in this art that the above embodiments are intended to be illustrated, and not restrictive. For example, many modifications may be made to the above embodiments by those skilled in this art, and various features described in different embodiments may be freely combined with each other without conflicting in configuration or principle.

Although several exemplary embodiments have been shown and described, it would be appreciated by those skilled in the art that various changes or modifications may be made in these embodiments without departing from the principles of the disclosure, the scope of which is defined in the claims and their equivalents.

As used herein, an element recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

## Claims

1. A 3D ink jet printing method, comprising steps of:
S100: constructing an ideal 3D digital model of a product to be printed;
S200: obtaining parameters of a conductive pattern to be printed on a surface of the product based on the constructed ideal 3D digital model;
S300: planning a printing path for the conductive pattern based on the obtained parameters of the conductive pattern;
S400: calculating working parameters of a robot and an ink jet print head based on the panned printing path;
S500: manipulating the robot and the ink jet print head to print the conductive pattern based on the calculated working parameters; and
S600: monitoring a print quality of the conductive pattern printed on the surface of the product and adjusting the working parameters in real time, so that the print quality meets preset requirements,
wherein the surface of the product comprises a 3D surface region, and the conductive pattern comprises a first conductive pattern printed on the 3D surface region of the product, and
wherein the robot adjusts a position and a posture of the product during printing, so that the product moves along the panned printing path relative to the ink jet print head in a state where the ink jet print head is always substantially perpendicular to a currently printed target surface region of the product.

2. The 3D ink jet printing method according to claim 1, wherein the ink jet print head is stationary during printing.

3. The 3D ink jet printing method according to claim 1, wherein the ink jet print head is movable in at least one of a first direction, a second direction and a third direction, which are perpendicular to each other.

4. The 3D ink jet printing method according to claim 1, wherein
during printing, an angle between an axis of the ink jet printing head and a normal line of the currently printed target surface region of the product is in a range of 0∼30 degrees.

5. The 3D ink jet printing method according to claim 1,
wherein the parameters of the conductive pattern comprise a shape, a size, a position and an orientation of the conductive pattern.

6. The 3D ink jet printing method according to claim 1,
wherein the working parameters of the robot comprise kinematic parameters and dynamic parameters of the robot; and
wherein the working parameters of the ink jet print head comprise an ink jetting frequency, an ink jetting flow rate, an ink temperature and an ink jet pressure.

7. The 3D ink jet printing method according to claim 1, wherein the step S600 comprises steps of:
S610: scanning the printed product with a 3D scanner and constructing an actual 3D digital model of the printed product;
S620: comparing the actual 3D digital model of the printed product and the ideal 3D digital model of the product; and
S630: determining whether or not a difference between the actual 3D digital model and the ideal 3D digital model is less than or equal to a preset threshold, and if not, adjusting the working parameters in real time until the difference becomes less than or equal to the preset threshold.

8. The 3D ink jet printing method according to claim 7,
wherein the working parameters are adjusted by a closed loop feedback control algorithm until the print quality meets the preset requirements.

9. The 3D ink jet printing method according to claim 8,
wherein the working parameters of the ink jet print head are controlled to match with the working parameters of the robot, so that the conductive pattern printed on the product has an even thickness.

10. The 3D ink jet printing method according to claim 1,
wherein the robot is movable in a first direction, a second direction and a third direction, which are perpendicular to each other; and
wherein the robot is rotatable about an axis in the first direction, an axis in the second direction and an axis in the third direction.

11. The 3D ink jet printing method according to claim 1,
wherein the first conductive pattern comprises a point, a curve or a 3D surface printed on the 3D surface region of the product.

12. The 3D ink jet printing method according to claim 1, wherein
during printing the first conductive pattern on the 3D surface region of the product, the robot is configured to adjust or the robot adjusts the posture of the product, so that an angle between a central axis of a nozzle (210) of the ink jet printing head and a normal line of the 3D surface region is in a range of 0∼30 degrees.

13. The 3D ink jet printing method according to claim 1,
wherein the surface of the product further comprises a 2D surface region, and wherein the conductive pattern further comprises a second conductive pattern printed on the 2D surface region of the product.

14. The 3D ink jet printing method according to claim 13,
wherein an ink jetting frequency and/or an ink jetting flow rate of the ink jet print head is configured to match with a movement speed of the robot, so that the printed first conductive pattern and/or the printed second conductive pattern has an even thickness.

15. The 3D ink jet printing method according to claim 13,
wherein the second conductive pattern comprises a point, a straight line, a curve or a 2D plane printed on the 2D surface region of the product.

## Patentansprüche

1. 3D-Tintenstrahldruckverfahren, das die folgenden Schritte umfasst:
S100: Konstruieren eines idealen digitalen 3D-Modells eines zu bedruckenden Erzeugnisses;
S200: Ermitteln von Parametern eines auf eine Oberfläche des Erzeugnisses aufzudruckenden leitenden Musters auf Basis des konstruierten idealen digitalen 3D-Modells;
S300: Planen eines Druckweges für das leitende Muster auf Basis der ermittelten erhaltenen Parameter des leitenden Musters;
S400: Berechnen von Arbeitsparametern eines Roboters und eines Tintenstrahl-Druckkopfes auf Basis des geplanten Druckweges;
S500: Manipulieren des Roboters und des Tintenstrahl-Druckkopfes zum Aufdrucken des leitenden Musters auf Basis der berechneten Arbeitsparameter; sowie
S600: Überwachen einer Druckqualität des auf die Oberfläche des Erzeugnisses aufgedruckten leitenden Musters und Anpassen der Arbeitsparameter in Echtzeit, so dass die Druckqualität vorgegebenen Anforderungen entspricht,
wobei die Oberfläche des Erzeugnisses einen 3D-Oberflächenbereich umfasst und das leitende Muster ein erstes leitendes Muster umfasst, das auf den 3D-Oberflächenbereich des Erzeugnisses aufgedruckt wird, und
der Roboter eine Position sowie eine Stellung des Produkts beim Drucken so anpasst, dass sich das Erzeugnis entlang des geplanten Druckweges in einem Zustand relativ zu dem Tintenstrahl-Druckkopf bewegt, in dem der Tintenstrahl-Druckkopf stets im Wesentlichen senkrecht zu einem aktuell bedruckten Ziel-Oberflächenbereich des Erzeugnisses ist.

2. 3D-Tintenstrahldruckverfahren nach Anspruch 1, wobei der Tintenstrahl-Druckkopf beim Drucken stationär ist.

3. 3D-Tintenstrahldruckverfahren nach Anspruch 1, wobei der Tintenstrahl-Druckkopf in einer ersten Richtung, einer zweiten Richtung oder/und einer dritten Richtung bewegt werden kann, die senkrecht zueinander sind.

4. 3D-Tintenstrahldruckverfahren nach Anspruch 1, wobei
beim Drucken ein Winkel zwischen einer Achse des Tintenstrahl-Druckkopfes und einer Senkrechten zu dem aktuell bedruckten Ziel-Oberflächenbereich des Erzeugnisses in einem Bereich von 0∼30° liegt.

5. 3D-Tintenstrahldruckverfahren nach Anspruch 1,
wobei die Parameter des leitenden Musters eine Form, eine Größe, eine Position und eine Ausrichtung des leitenden Musters umfassen.

6. 3D-Tintenstrahldruckverfahren nach Anspruch 1,
wobei die Arbeitsparameter des Roboters kinematische Parameter sowie dynamische Parameter des Roboters umfassen; und
die Arbeitsparameter des Tintenstrahl-Druckkopfes eine Tintenstrahl-Frequenz, eine Tintenstrahl-Strömungsgeschwindigkeit, eine-Temperatur sowie einen Tintenstrahl-Druck umfassen.

7. 3D-Tintenstrahldruckverfahren nach Anspruch 1, wobei der Schritt S600 die folgenden Schritte umfasst:
S610: Scannen des bedruckten Erzeugnisses mit einem 3D-Scanner und Konstruieren eines tatsächlichen digitalen 3D-Modells des bedruckten Erzeugnisses;
S620: Vergleichen des tatsächlichen digitalen 3D-Modells des bedruckten Erzeugnisses mit dem idealen digitalen 3D-Modell des Erzeugnisses; sowie
S630: Feststellen, ob ein Unterschied zwischen dem tatsächlichen digitalen 3D-Modell und dem idealen digitalen 3D-Modell unter oder auf einem vorgegebenen Schwellenwert liegt, und, wenn dies nicht der Fall ist, Anpassen der Arbeitsparameter in Echtzeit, bis der Unterschied unter oder auf dem vorgegebenen Schwellenwert liegt.

8. 3D-Tintenstrahldruckverfahren nach Anspruch 7,
wobei die Arbeitsparameter durch einen Regelungs-Algorithmus angepasst werden, bis die Druckqualität die vorgegebenen Anforderungen erfüllt.

9. 3D-Tintenstrahldruckverfahren nach Anspruch 8,
wobei die Arbeitsparameter des Tintenstrahl-Druckkopfes so gesteuert werden, dass sie mit den Arbeitsparametern des Roboters so übereinstimmen, dass das auf das Erzeugnis aufgedruckte leitende Muster eine gleichmäßige Dicke hat.

10. 3D-Tintenstrahldruckverfahren nach Anspruch 1,
wobei der Roboter in einer ersten Richtung, einer zweiten Richtung und einer dritten Richtung bewegt werden kann, die senkrecht zueinander sind; und
der Roboter um eine Achse in der ersten Richtung, eine Achse in der zweiten Richtung sowie eine Achse in der dritten Richtung gedreht werden kann.

11. 3D-Tintenstrahldruckverfahren nach Anspruch 1,
wobei das erste leitende Muster einen Punkt, eine Kurve oder eine 3D-Oberfläche umfasst, der/die auf den 3D-Oberflächenbereich des Erzeugnisses aufgedruckt wird.

12. 3D-Tintenstrahldruckverfahren nach Anspruch 1, wobei
der Roboter so eingerichtet ist, dass er beim Aufdrucken des ersten leitenden Musters auf den 3D-Oberflächenbereich des Erzeugnisses die Stellung des Erzeugnisses anpasst, oder der Roboter die Stellung des Erzeugnisses so anpasst, dass ein Winkel zwischen einer Mittelachse einer Düse (210) des Tintenstrahl-Druckkopfes und einer Senkrechten zu dem 3D-Oberflächenbereich in einem Bereich von 0∼30° liegt.

13. 3D-Tintenstrahldruckverfahren nach Anspruch 1,
wobei die Oberfläche des Erzeugnisses des Weiteren einen 2D-Oberflächenbereich umfasst und das leitende Muster des Weiteren ein zweites leitendes Muster umfasst, das auf den 2D-Oberflächenbereich des Erzeugnisses gedruckt wird.

14. 3D-Tintenstrahldruckverfahren nach Anspruch 13,
wobei eine Tintenstrahl-Frequenz und/oder eine Tintenstrahl-Strömungsgeschwindigkeit des Tintenstrahl-Druckkopfes so eingerichtet sind/ist, dass sie mit einer Bewegungsgeschwindigkeit des Roboters übereinstimmen/übereinstimmt, so dass das aufgedruckte erste leitende Muster und/oder das aufgedruckte zweite leitende Muster eine gleichmäßige Dicke haben/hat.

15. 3D-Tintenstrahldruckverfahren nach Anspruch 13,
wobei das zweite leitende Muster einen Punkt, eine gerade Linie, eine Kurve oder eine 2D-Ebene umfasst, der/die auf den 2D-Oberflächenbereich des Erzeugnisses aufgedruckt wird.

## Revendications

1. Procédé d'impression à jet d'encre en 3D, comprenant les étapes suivantes:
S100: construction d'un modèle numérique en 3D idéal d'un produit à imprimer;
S200: obtention des paramètres d'un motif conducteur à imprimer sur une surface du produit sur la base du modèle numérique en 3D idéal construit;
S300: planification d'un chemin d'impression pour le motif conducteur sur la base des paramètres obtenus du motif conducteur;
S400: calcul des paramètres de fonctionnement d'un robot et d'une tête d'impression à jet d'encre sur la base du chemin d'impression en panoramique;
S500: manipulation du robot et de la tête d'impression à jet d'encre pour imprimer le motif conducteur en fonction des paramètres de travail calculés; et
S600: contrôle de la qualité d'impression du motif conducteur imprimé sur la surface du produit et ajustement des paramètres de travail en temps réel, de sorte que la qualité d'impression réponde aux exigences prédéfinies,
dans lequel la surface du produit comprend une zone de surface en 3D et le motif conducteur comprend un premier motif conducteur imprimé sur la zone de surface en 3D du produit, et
dans lequel le robot ajuste une position et une posture du produit pendant l'impression, de sorte que le produit se déplace le long du trajet d'impression panoramique par rapport à la tête d'impression à jet d'encre pour que la tête d'impression à jet d'encre soit toujours sensiblement perpendiculaire à une cible actuellement imprimée zone de surface du produit.

2. Procédé d'impression à jet d'encre en 3D selon la revendication 1, dans lequel la tête d'impression à jet d'encre est stationnaire pendant l'impression.

3. Procédé d'impression à jet d'encre en 3D selon la revendication 1, dans lequel la tête d'impression à jet d'encre est mobile dans au moins une première direction, une deuxième direction et une troisième direction, lesquelles sont perpendiculaires les unes aux autres.

4. Procédé d'impression à jet d'encre en 3D selon la revendication 1, dans lequel
pendant l'impression, un angle entre un axe de la tête d'impression à jet d'encre et une ligne normale de la zone de surface cible actuellement imprimée du produit se situe dans une plage allant de 0 à 30 degrés.

5. Procédé d'impression à jet d'encre en 3D selon la revendication 1,
dans lequel les paramètres du motif conducteur comprennent une forme, une taille, une position et une orientation du motif conducteur.

6. Procédé d'impression à jet d'encre en 3D selon la revendication 1,
dans lequel les paramètres de fonctionnement du robot comprennent des paramètres cinématiques et des paramètres dynamiques du robot; et
dans lequel les paramètres de travail de la tête d'impression à jet d'encre comprennent une fréquence de jet d'encre, un débit de jet d'encre, une température d'encre et une pression de jet d'encre.

7. Procédé d'impression à jet d'encre en 3D selon la revendication 1, dans lequel l'étape S600 comprend les étapes suivantes:
S610: numériser le produit imprimé avec un scanner en 3D et construire un modèle numérique en 3D réel du produit imprimé;
S620: comparer le modèle numérique en 3D réel du produit imprimé et le modèle numérique en 3D idéal du produit; et
S630: déterminer si une différence entre le modèle numérique en 3D réel et le modèle numérique en 3D idéal est inférieure ou égale à un seuil prédéfini, et si ce n'est pas le cas, ajuster les paramètres de travail en temps réel jusqu'à ce que la différence devienne inférieure ou égale au seuil prédéfini.

8. Procédé d'impression à jet d'encre en 3D selon la revendication 7,
dans lequel les paramètres de travail sont ajustés par un algorithme de contrôle de retour en boucle fermée jusqu'à ce que la qualité d'impression réponde aux exigences prédéfinies.

9. Procédé d'impression à jet d'encre en 3D selon la revendication 8,
dans lequel les paramètres de travail de la tête d'impression à jet d'encre sont contrôlés pour correspondre aux paramètres de travail du robot pour que le motif conducteur imprimé sur le produit ait une épaisseur uniforme.

10. Procédé d'impression à jet d'encre en 3D selon la revendication 1,
dans lequel le robot est mobile dans une première direction, une deuxième direction et une troisième direction, qui sont perpendiculaires les unes aux autres; et
dans lequel le robot peut tourner autour d'un axe dans la première direction, d'un axe dans la deuxième direction et d'un axe dans la troisième direction.

11. Procédé d'impression à jet d'encre en 3D selon la revendication 1,
dans lequel le premier motif conducteur comprend un point, une courbe ou une surface en 3D imprimée sur la zone de surface en 3D du produit.

12. Procédé d'impression à jet d'encre en 3D selon la revendication 1, dans lequel
lors de l'impression du premier motif conducteur sur la zone de surface en 3D du produit, le robot est configuré pour ajuster ou le robot ajuste la posture du produit, de sorte qu'un angle entre un axe central d'une buse (210) de l'impression à jet d'encre tête et une ligne normale de la zone de surface en 3D se situe dans une plage de 0 à 30 degrés.

13. Procédé d'impression à jet d'encre en 3D selon la revendication 1,
dans lequel la surface du produit comprend une zone de surface en 2D et le motif conducteur comprend un premier motif conducteur imprimé sur la zone de surface en 2D du produit.

14. Procédé d'impression à jet d'encre en 3D selon la revendication 13,
dans lequel une fréquence de jet d'encre et/ou un débit de jet d'encre de la tête d'impression à jet d'encre est configuré pour correspondre à une vitesse de déplacement du robot, pour que le premier motif conducteur imprimé et/ou le deuxième motif conducteur imprimé aient une épaisseur régulière.

15. Procédé d'impression à jet d'encre en 3D selon la revendication 13,
dans lequel le deuxième motif conducteur comprend un point, une ligne droite, une courbe ou un plan en 2D imprimé sur la zone de surface en 2D du produit.
